# EUROPEAN PATENT APPLICATION

(11) **EP 4 838 560 A1**
(43) Date of publication of application: **11.11.2026**
(21) Application number: 25174220.1
(22) Date of filing: 05.05.2025
(51) Int. Cl.: H01L 23/48, H01L 21/68, H01L 23/544

(54) **METHOD OF BONDING DONOR SUBSTRATES TO AN ACCEPTOR SUBSTRATE**

(71) Applicant: ASML Netherlands B.V., 5500 AH Veldhoven (NL)
(72) Inventor: BANINE, Vadim Yevgenyevich, 5500 AH Veldhoven (NL); RENKENS, Michael Jozefa Mathijs, 5500 AH Veldhoven (NL); DEKKERS, Jeroen, 5500 AH Veldhoven (NL); RAMOS, André Filipe Lemos Antunes Palma, 5500 AH Veldhoven (NL)
(74) Representative: ASML Netherlands B.V.

(57) **Abstract**

The invention concerns a method of bonding one or more donor substrates to an acceptor substrate. The method comprises: determining a distortion of the acceptor substrate due to bonding of a preceding donor substrate to the acceptor substrate; determining a placement error made in bonding a subsequent donor substrate due to said distortion for a plurality of target positions on the distorted acceptor substrate; and determining a preferred target position based on the determined placement error.

## Description

### TECHNICAL FIELD

The present disclosure relates generally to a method of bonding donor substrates to an acceptor substrate, a bonding tool, a bonding system, and computer program comprising instructions.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die - where these specific portions which may be aligned in three-dimensional space to ensure functional connectivity. Alignment of these die, which may have multiple fabrication layers, different critical dimensions, different nodes, packaging, etc., with each other may require different techniques than use for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another.

In the context of semiconductor manufacture, improvements in die placement and alignment (e.g., improvements in heterogeneous integration) lead to improvements in IC manufacturing and integration abilities.

### SUMMARY

According to an embodiment, there is provided a method of bonding one or more donor substrates to an acceptor substrate. The method comprises: determining a distortion of the acceptor substrate due to bonding of a preceding donor substrate to the acceptor substrate; determining a placement error made in bonding a subsequent donor substrate due to said distortion for a plurality of target positions on the distorted acceptor substrate; and determining a preferred target position based on the determined placement error.

According to an embodiment, there is provided a method of bonding one or more donor substrates to an acceptor substrate. The method comprises: determining a distortion of the acceptor substrate due to bonding of one or more preceding donor substrates to the acceptor substrate; determining a placement error made in bonding a subsequent donor substrate due to said distortion at a preferred target position; and placing the subsequent donor substrate at a corrected target position based on the determined placement error at the preferred target position.

According to an embodiment, there is provided a computer program comprising instructions configured to control a semiconductor bonding system to perform the method.

According to an embodiment, there is provided a bonding tool for bonding donor substrates to an acceptor substrate. The bonding tool is configured to position a subsequent donor substrate at a preferred target position based on a determined placement error due to distortion of the acceptor substrate due to bonding of a preceding donor substrate to the acceptor substrate.

According to an embodiment, there is provided a bonding system for bonding donor substrates to an acceptor substrate. The bonding system comprises the bonding tool and a determination unit. The determination unit is configured to: determine a distortion of the acceptor substrate due to bonding of a preceding donor substrate to the acceptor substrate; determine a placement error made in bonding a subsequent donor substrate due to said distortion for a plurality of target positions on the distorted acceptor substrate; and determine the preferred target position based on the determined placement error.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figure 2 is a schematic diagram illustrating a method of placement of dies by a moveable stage with recesses, according to an embodiment.
Figure 3 is a schematic diagram illustrating different potential types of distortion (e.g., deformation and/or misalignment) that may be present in a substrate prior to bonding, according to an embodiment.
Figure 4A-C are schematic diagrams illustrating: an acceptor substrate, without distortion, prior to bonding of donor substrates; the acceptor substrate with distortion due to bonding of a first set of donor substrates; and the acceptor substrate with a subsequently bonded second set of donor substrates, which are subject to placement error due to the distortion.
Figure 5A-D are schematic diagrams illustrating: an acceptor substrate prior to bonding of donor substrates; the acceptor substrate with a first set of donor substrates placed symmetrically thereon; the acceptor substrate with a second set of donor substrates placed symmetrically thereon; and the acceptor substrate with a third set of donor substrates placed symmetrically thereon.
Figure 6 is a block diagram of an example computer system, according to an embodiment.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

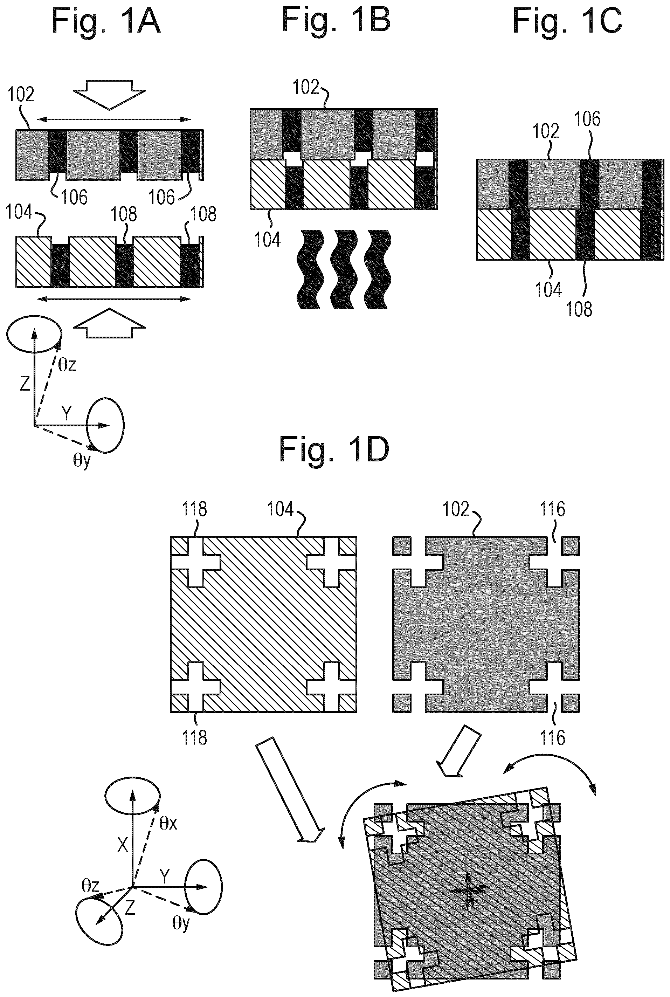

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1 A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1 A, the donor die 102 and the target die 104 may be brought together along the z-axis, while the position of the donor die 102 or the target die 104 may be adjusted in the x-y plane (e.g., perpendicular to the z-axis of approach). As shown in Figure IB, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non- zero linewidth portion of the wafer volume when separating die. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

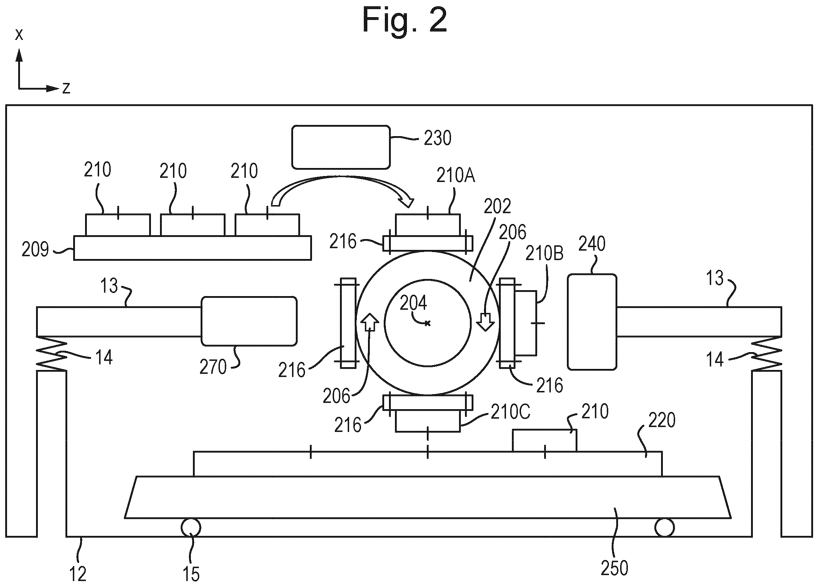

Figure 2 is a schematic diagram illustrating a method of placement of donor dies by a moveable stage with recesses. Figure 2 is described with reference to "donor die" and "target die", which are relative descriptors and donor die may instead be target die and vice versa. Figure 2 is a cross-sectional view of placement of donor die 210A-210D using support stage 202. The support stage 202 is substantially circular in the x-z plane, with a longitudinal axis 204 along the y-direction (e.g., the support stage 202 is substantially cylindrical in three dimensions). The support stage 202 may instead have a different cross-sectional shape, such as square, hexagonal, etc. The support stage 202 may have a symmetrical (e.g., as shown) cross-section with one or more axis of symmetry, or asymmetrical cross-sectional area (for example, an irregular polygon).

The support stage 202 has die acceptors 216. The placement of the die acceptors 216 may be symmetrical or asymmetrical around the cross-sectional area of the support stage 202. The support stage 202 may have a substantially symmetrical cross section but have asymmetric placement of recesses. For example, the support stage 202 may have a cross-section that is a regular hexagon but have recesses placed asymmetrically along longitudinal faces. The die acceptors 216 are capable of accepting donor dies, such as the donor dies 210A- 210D.

The support stage 202 may be controllably moved in a direction 206 about the longitudinal axis 204. The direction 206 is provided as an example. The support stage 202 may instead be rotated in an opposite direction or any appropriate direction, translated along the x, y, or z direction or any combination thereof. The support stage 202 may be operated in both rotational and a translational modes, including sequentially or at the same time. For example, the support stage 202 may move in the negative x-direction towards a support structure 250 while also rotating about the longitudinal axis 204. The support stage 202 may move continuously or intermittently. For example, the support stage 202 may rotate in the direction 206 and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the support stage 202 is substantially zero), but the positions may instead correspond to continuous (or quasi-continuous movement) or operations may occur while the support stage 202 is moving in one or more directions (e.g., rotationally, translationally, etc.).

A first position, such as corresponding to the position depicted for the donor die 210A, may correspond to placement of die in die acceptors 216 of the support stage 202. The donor die 210A may be placed on the die acceptor 216 by a pick and place element 230. The pick and place element 230 may place the donor die 210A on the support stage 202 on the die acceptor 216 based on alignment information, based on positional information of the support stage 202, etc. The pick and place element 230 may place the donor die 210A on the support structure at a given position relative to the die acceptor 216. For example, the pick and place element 230 may center the donor die 210A relative to the die acceptor 216. The pick and place element 230 may have intrinsic error or inaccuracy.

The second position, such as corresponding to the position depicted for the donor die 210B, may correspond to measurement of the position of the die in recesses (e.g., of the donor die 210B relative to the die acceptor 216) of the support stage 202. The position (e.g., location) of the donor die 210B may be measured by a location measurement element 240. The location measurement element 240 may measure an actual position of the donor die 210B, in relative (such as relative to the die acceptor 216) or absolute terms (such as in distances from an origin point on the support stage 202, on the location measurement element 240, etc.). The location measurement element 240 may be a camera, e.g., a two-dimensional camera, two or more one-dimensional cameras, an optical camera, etc., or another measurement device. The location measurement element 240 may be made up of multiple location measurement elements, such as an inplane measurement device which may measure locations in the y-z plane (relative to the refence axes) and an out of plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the support stage 202.

Once the position of the donor die 210B is measured, the support stage 202 may move (e.g., in the direction 206), so that the donor die 210B occupies the position of the donor die 210C which may be a third position of the support stage 202. The third position of the support structure will now be described with reference to the donor die 210C.

The third position, such as corresponding to the position depicted for the donor die 210C, may correspond to placement of the die on a corresponding target, for example, an acceptor substrate 220. The acceptor substrate 220 may comprise one or more target dies which may be sequentially contacted by a donor die during various movements of the support stage 202.

The acceptor substrate 220 is supported by the support structure 250. The donor die 210C may be placed on the acceptor substrate 220 by motion of the support stage 202 towards the acceptor substrate 220. Alternatively or additionally, the support structure 250 may also be a moveable structure operable to bring the donor die 210C and the acceptor substrate 220 into contact.

Once the donor die 210C is placed on the acceptor substrate 220, the support stage 202 and the support structure 250 may operate (individually or in concert) to place additional donor dies on the acceptor substrate 220. For example, the support structure 250 may move in the negative z-direction so that another part of the acceptor substrate 220 is proximate to the support stage 202 and a donor die (for example, the donor die 210B after rotation of the support stage 202) may be placed on the acceptor substrate 220. The relative motion of the support stage 202 and the support structure 250 may occur in any appropriate direction. A direction of gravity is not depicted, but the placement of the donor die 210C on the acceptor substrate 220 may experience gravitation effects. For example, the placement of the donor die 210C on the acceptor substrate 220 may be encouraged by gravity (e.g., occur in the direction of gravity) or be retarded by gravity (e.g., occur opposite the direction of gravity). Gravitational effects may be balanced by die clamps, suction, vacuum, and other forces.

The stage 202 shown in Figure 2 is for die placement. The stage 202 is for placing dies 210, for example onto an acceptor substrate 220. The stage 202 comprises an actuator. The actuator is configured to cause the stage 202 to accept the dies 210 from pick & place element 230 and subsequently transport the dies 210 to alignment sensor 240 and finally place the dies 210 on the acceptor substrate 220.

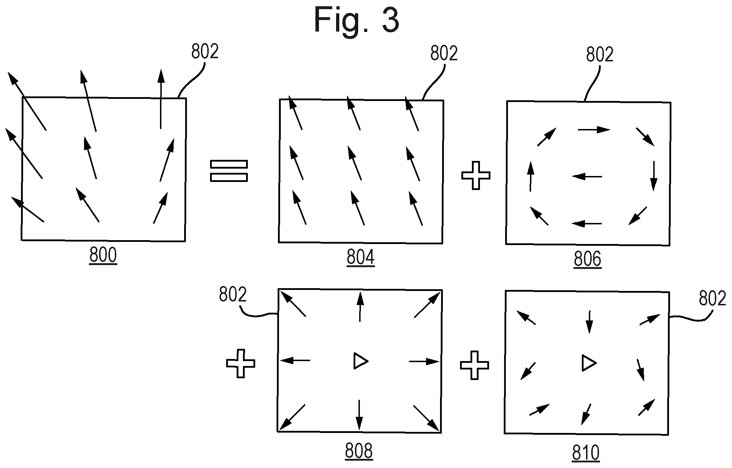

Figure 3 illustrates different potential types of deformation, misalignment, and/or other distortion 800 that may be present in a substrate 802 (e.g., a first substrate 208 and/or second substrate 230) prior to bonding. As shown in Figure 3 substrate 802 (e.g., a die, wafer, and/or other substrates) may have some amount of distortion 800 made up of translational distortion 804 (or misalignment), rotational distortion 806 (or misalignment), magnification distortion 808, and/or other residual distortion 810 (or misalignments) that needs to be corrected prior to bonding. Note that translation and rotation may not technically be distortions, but free body movements or misalignments. These can be corrected by moving a substrate relative to a carrier wafer, for example. However, for the purposes of this patent application, it can be useful to think of these generally in terms of distortion, in that the present systems and methods are configured to move one or more features from a first position (e.g., a distorted or unexpected or misaligned position, which can have many causes) to a second, expected position, as described herein.
Typical distortion for a 10mm die of 50 µm thickness (as one representative example) is on the order of about 300nm. The four components of the distortion described above - translation, rotation, magnification, and residue - may have mean values of about 200nm, 20nm, 150n, and 20nm, respectively (in this example). With typical bonding process controls, only translational distortion (e.g., from about 200nm to about 20nm) and rotational distortion (e.g., from about 3 mRad to about 3 nRad) can be corrected. This correction may be accomplished by actuation of donor die holders and/or actuation of a wafer stage, for example.

Bonding of donor substrates (e.g., dies) to an acceptor substrate (e.g., a sample or wafer) can result in distortion of the acceptor substrate. The distortion of the acceptor substrate may influence the accuracy of placement of subsequent donor substrates. For example, deformation due the bonding of a donor substrate may result in distortions, for example of an order of hundreds of nanometers, locally in a region of the bonding, on the acceptor substrate. However, particularly when a plurality of donor substrates is bonded to the acceptor substrate, there can be a more significant global deformation across the acceptor substrate. In some instances, the donor substrates may be significantly thicker (e.g., ten times thicker) than the acceptor substrate. The difference of the thickness between the donor substrate and the acceptor substrate, combined with grouping of the donor substrates over particular regions of the acceptor substrate, can result in global deformations reaching the order of several tens of nanometers.

In some known processes, a rectangular grid is provided on the acceptor substrate to aid in identifying potential locations (e.g., die stations) at which the donor substrates may be bonded to the acceptor substrate. The grid is most commonly used for calibration purposes, prior to bonding any donor substrates on the acceptor substrate. It is then assumed that the grid does not change as the donor substrates are bonded to the acceptor substrate. However, this assumption of the unchanging grid might be not correct, particularly for systems with otherwise high positioning accuracies (e.g. in an order of tens of nanometers) due to the deformation induced by bonded donor substrates onto the acceptor substrate. Therefore, as systems/tools for bonding of donor substrates onto acceptor substrates become capable of ever more accurate placement, the relative influence of distortion, caused by bonding of donor substrates, becomes more significant on the overall accuracy of donor substrate placement.

As explained above, the bonding of donor substrates to the acceptor substrate may result in distortion of the acceptor substrate. This distortion of the acceptor substrate may also distort the grid on the surface of the acceptor substrate to which the donor substrates are to be bonded. This can introduce a problem of correct positioning of subsequent donor substrates on the acceptor substrate. In particular, unless action is taken to account for this issue, the subsequent donor substrates will be placed based on the original position of the grid, prior to bonding of any donor substrates to the acceptor substrate. In practice, due to distortion of the acceptor substrate, the grid will be distorted such that there will be a difference between the intended placement position of the subsequent donor substrate and the actual position on the grid at which the subsequent donor substrate is placed. This difference may therefore be considered to represent an error in placement of the subsequent donor substrates.

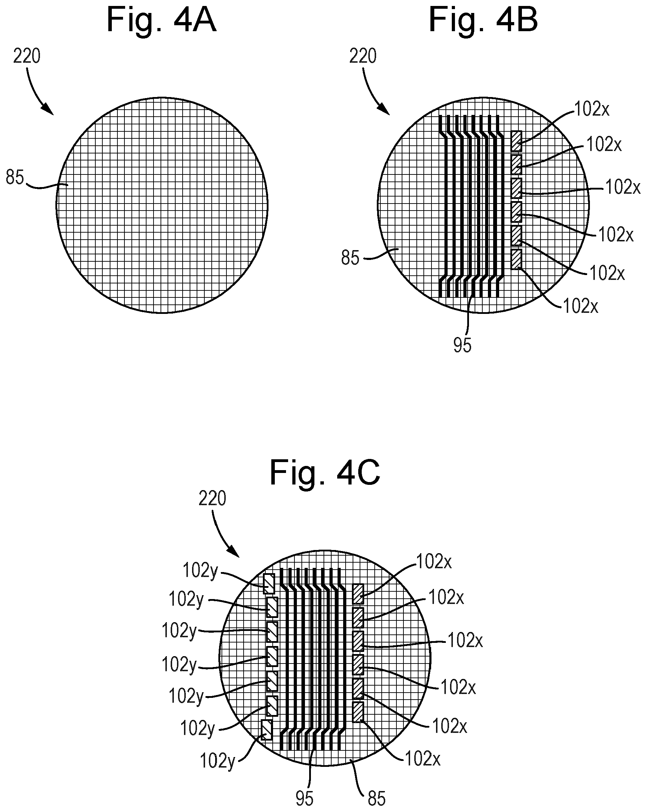

Figures 4A-C are schematic diagrams illustrating an acceptor substrate 220 without and with donor substrates 102 bonded thereon. Figure 4A shows the acceptor substrate 220, without distortion of the grid 85, prior to bonding of donor substrates 102. Figure 4B shows the acceptor substrate 220 with distortion 95 of the grid 85 due to bonding of a first set of donor substrates 102x. Figure 4C shows the acceptor substrate 220 with a subsequently bonded second set of donor substrates 102y, which are subject to placement error due to the distortion 95 of the grid 85. In other words, the expected position of the grid, based on the grid 85 on the acceptor substrate 220, of Figure 4A, prior to bonding of any donor substrates 102 does not match the actual position of the grid 85 with distortion 95 after bonding of the first set of donor substrates 102x. Thus, if the second set of donor substrates 102y are placed based on the expected position of the grid, there will be a placement error for the donor substrates in the second set of donor substrates 102y. The placement error may be quantified based on a difference between an intended position of the donor substrates 102y on the acceptor substrate 220 and the actual position of the donor substrates 102y on the acceptor substrate 220.

The influence of distortion of the acceptor substrate 220 may be reduced by applying particular methods of bonding the donor substrates 102 to the acceptor substrate 220. In particular, the donor substrates 102 may be bonded at positions on the acceptor substrate 220 which may be selected to reduce distortion of the acceptor substrate 102 due to bonding of the donor substrates 102. A method for bonding one or more donor substrates to an acceptor substrate comprises the following steps:
i) determining a distortion of the acceptor substrate 220 due to bonding of a preceding donor substrate 102x to the acceptor substrate 220;
ii) determining a placement error made in bonding a subsequent donor substrate 102y due to said distortion for a plurality of target positions on the distorted acceptor substrate 220;
   and
iii) determining a preferred target position based on the determined placement error.

In other words, the distortion of the acceptor substrate 220 due to the bonding of one or more already bonded donor substrates 102x (i.e., the preceding donor substrate) is taken into consideration when selecting a preferred target position on the acceptor substrate 220 at which to place another donor substrate 102y (i.e., the subsequent donor substrate). In other words, a plurality of target positions may be analysed to determine the placement error associated with placing the subsequent donor substrate 102y at each of those positions, due to the distortion caused by bonding of one or more preceding donor substrates 102x to the acceptor substrate 220. The determined placement errors may then be used to inform the selection of the preferred target position, at which to place the subsequent donor substrate 102y, from among the plurality of target positions on the acceptor substrate 220.

For example, the preferred target position may be the target position, from among the plurality of target positions, associated with the smallest placement error. Alternatively, the preferred target position may be selected from among any identified target positions, from among the plurality of target positions, associated with a placement error which is equal to or less than a predetermined placement error threshold. The predetermined placement error threshold may be 20 nm, preferably 10 nm, more preferably 5 nm, yet more preferably 3 nm. In other words, the preferred target position is determined based on prioritising target positions which have the smallest placement error and/or a placement error not exceeding the predetermined placement error threshold. Alternatively, or additionally, the placement error may be only one of a plurality of factors (i.e., parameters) which are used to inform the selection of the preferred target position from the plurality of target positions. In this way, the errors in placement of the donor substrates 102 may be reduced compared to an alternative method where the donor substrates 102 are placed in different positions and/or in a different sequence. For example, as shown in Figures 4A-C, placing a plurality of donor substrates 102x in close proximity to each other may result in global distortion of the acceptor substrate 220 which may, in turn, increase placement errors in the placement of subsequent donor substrates 102y.

The subsequent donor substrate 102y may then be placed at the determined preferred target position, and bonded to the acceptor substrate 220 at that preferred target position. These steps may be repeated in order to determine preferred target positions for a plurality of donor substrates 102. In this manner, each donor substrate for which a preferred target position has already been determined, may then be considered as a preceding donor substrate 102x. The process may, optionally, continue until there are no remaining, unoccupied target positions at which a subsequent donor substrate 102y could be placed. In other words, the process may be continued until each of the plurality of target positions have been determined to be a preferred target position for a respective donor substrate 102.

The subsequent donor substrates 102y may be bonded to the acceptor substrate 220 after the entire sequence of positioning donor substrates 102y at the respective preferred target positions has been determined. Alternatively, each subsequent donor substrate 102y may be bonded to the acceptor substrate 220 at any time after the corresponding preferred target position of that subsequent donor substrate 102y has been determined, including after that preferred target position has been determined and before the preferred target position of a next subsequent donor substrate 102y has been determined. In other words, the bonding of donor substrates 102 may be carried out before repeating steps i to iii for a next subsequent donor substrate 102y, or the bonding of donor substrates 102 may be carried out after steps i to iii have been repeated a plurality of times.

The method may be carried out using a bonding tool for bonding a plurality of donor substrates 102 to an acceptor substrate 220. The bonding tool is configured to position the subsequent donor substrate 102y at the respective determined preferred target position. The determined preferred target position is based on the determined placement error due to distortion of the acceptor substrate 220. The placement error is the placement error caused by bonding of one or more preceding donor substrates 102x to the acceptor substrate 220. The bonding tool may, optionally, comprise a moveable stage with recesses, such as described above in reference to Figure 2. Alternatively, the bonding tool may have a different arrangement to that shown in Figure 2. For example, the bonding tool may optionally comprise one or more robotic arms configured to place the subsequent donor substrates 102y at the respective determined preferred target positions.

The bonding tool may be comprised within a bonding system for bonding a plurality of donor substrates to an acceptor substrate. The bonding system comprises the bonding tool and a determination unit. The determination unit may be configured to: determine a distortion of the acceptor substrate 220 due to bonding of a preceding donor substrate 102x to the acceptor substrate 220; determine a placement error made in bonding the subsequent donor substrate 102y due to said distortion for a plurality of target positions on the distorted acceptor substrate 220; and determine the preferred target position based on the determined placement error. The determination unit may be comprised of one or more sub-units. Each sub-unit may be configured to perform one or more of steps i to iii of the method as described above.

The plurality of target positions on the acceptor substrate 220, which are considered as possible positions for placement of the subsequent donor substrate 102y, may include all positions on the acceptor substrate 220 which are not already occupied by a preceding donor substrate 102x. Alternatively, there may be some regions of the acceptor substrate which are not included in the plurality of target positions. For example, there may be regions on the acceptor substrate 220 which are reserved for other features or which are difficult to access for bonding of donor substrates 102, for example due to the geometry and/or range of motion of components of the bonding tool. Furthermore, there may be predetermined desired positions of donor substrates 102 on the acceptor substrate 220, in one or more regions on the acceptor substrate 220 at which it is desirable for one or more donor substrate 102 to be positioned.

The location of each target position, of the plurality of target positions, may for example be based on any relevant information. The selection of the preferred target position for the subsequent donor substrate 102y to be placed may also be based on any relevant information. The relevant information may be referred to as placement information. The placement information may, for example, comprise information selected from the following group: geometry of the acceptor substrate 220, positions of features on the acceptor substrate 220, positions of any preceding donor substrates 102x already bonded to the acceptor substrate 220, predetermined desired positions of donor substrates 102 on the acceptor substrate 220, surface activation energy of the acceptor substrate 220, geometry of a clamp used to hold the donor substrate 102 during placement of the donor substrate 102 for bonding on the acceptor substrate 220, a range of motion of an actuated stage on which the acceptor substrate 220 is supported, a range of motion of an actuated system for placing the donor substrate 102 on the acceptor substrate 220, a speed of motion of the actuated stage, and/or a speed of motion of the actuated system for placing the donor substrate 102 on the acceptor substrate 220.

The geometry of the acceptor substrate 220 may, for example, comprise a shape, size and topography of the acceptor substrate 220. There may, for example, be positions on the acceptor substrate 220 which will not be suitable as target positions because these positions may be occupied by other features on the acceptor substrate 220, or it may be intended that these positions will subsequently be occupied by other features not yet present on the acceptor substrate 220. Conversely, there may be predetermined desired positions of donor substrates 102 on the acceptor substrate 220. These may be one or more predetermined desired positions on the acceptor substrate 220, at which it has been predetermined that a donor substrate 102 will be placed. The geometry (e.g., the shape and/or size) of the clamp used to hold the donor substrate 102 during placement of the donor substrate 102 for bonding on the acceptor substrate 220 may be relevant to determine the practical positions on the acceptor substrate 220 which are readily accessible for placement of donor substrates 102. In other words, information regarding the geometry of the clamp may be used to exclude positions at which it would be impossible, or impractical, to place a donor substrate 102 due to lack of accessibility.

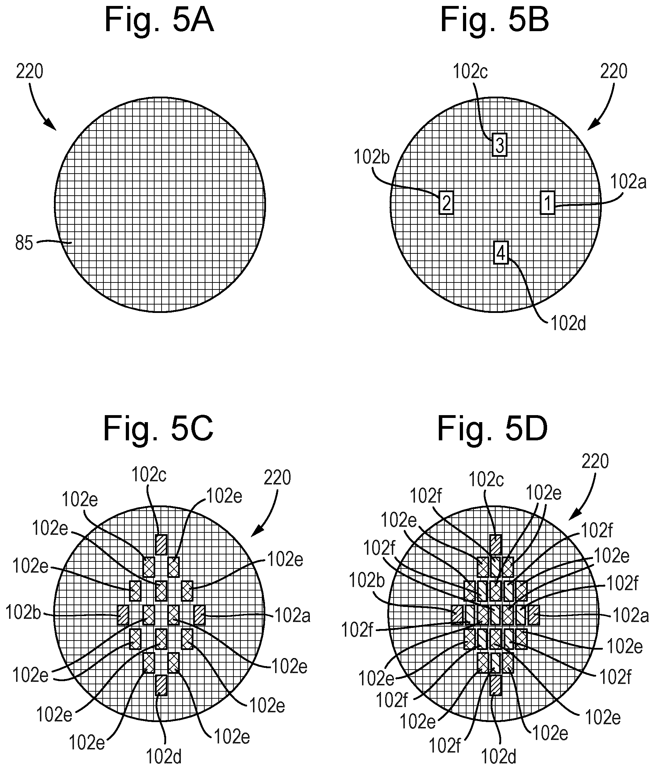

Figure 5A-D are schematic diagrams illustrating different stages in a process of bonding a plurality of donor substrates 102 to an acceptor substrate 220. Figure 5A shows the acceptor substrate 220 prior to bonding of donor substrates. In Figure 5A, the acceptor substrate 22 has no donor substrates 102 bonded thereto, and therefore the acceptor substrate 220 at this stage will have no distortion due to bonding of a preceding donor substrate to the acceptor substrate 220. As described above, the donor substrates 102 are placed on, and bonded to, the acceptor substrate 220 in an order intended to reduce placement errors of subsequent donor substrates 102y resulting from distortion of the acceptor substrate 220 due to the bonding of preceding donor substrates 102x to the acceptor substrate 220.

Figure 5B shows the acceptor substrate 220 with a first set of donor substrates 102a-d bonded thereon. Figure 5C shows the acceptor substrate with both the first set of donor substrates 102a-d bonded thereon and a second set of donor substrates 102e bonded thereon. In other words, Figure 5C shows the acceptor substrate 220 after bonding of the first set of donor substrates 102a-d, and the second set of donor substrates 102e to the acceptor substrate 220. Figure 5D shows the acceptor substrate with the first and second sets of donor substrates 102a-e and a third set of donor substrates 102f bonded thereon. In other words, Figure 5D shows the acceptor substrate 220 after bonding of the first and seconds sets of donor substrates 102a-e, and the third set of donor substrates 102f to the acceptor substrate 220.

At any stage, or all stages, in the process, the preferred target position for the subsequent donor substrate 102 to be placed on and bonded to the acceptor substrate 220 may be determined based on predetermined prioritisation criteria. The different criteria may be given a different weighting of importance in prioritising which target position to select as the preferred target position at which to place the subsequent donor substrate 102 may be based on user choice and/or the particular requirements of a given situation.

The preferred target position may be determined based on criteria prioritising target positions which are either: in a position which is symmetric on the acceptor substrate 220 to an occupied position at which a preceding donor substrate is bonded; or, in a position which is symmetric on the acceptor substrate 220 to another target position, at which another donor substrate may be subsequently bonded. In particular, there may be a first target position located on the surface of the acceptor substrate 220, and a second target position located at a position symmetric to the first target position on the surface of the acceptor substrate 220, relative to the centre of the surface of the acceptor substrate 220. In other words, the first target position and the second target positions may be equidistant from the centre of the surface of the acceptor substrate 220 and disposed in opposite in-plane directions from the centre of the surface of the acceptor substrate 220. For example, in Figure 5B, the first donor substrate 102a has been bonded at a target position which is in a position which is symmetric on the acceptor substrate 220 to another target position, at which another donor substrate may be subsequently bonded. The second donor substrate 102b, in the arrangement of Figure 5B, has then been bonded in a position which is symmetric on the acceptor substrate 220 to an occupied position at which the first donor substrate 102a is bonded. Likewise, in Figure 5B, the third donor substrate 102c has been bonded at a target position which is in a position which is symmetric on the acceptor substrate 220 to another target position, at which another donor substrate may be subsequently bonded. The fourth donor substrate 102d, in the arrangement of Figure 5B, has then been bonded in a position which is symmetric on the acceptor substrate 220 to an occupied position at which the third donor substrate 102c is bonded. In this way, the distortion of the acceptor substrate 220 due to bonding of the donor substrates 102 may be reduced, compared to more asymmetric positioning of the donor substrates (for example, as shown in Figure 4A-C). Consequently, the placement error associated with bonding donor substrates 102 in the order as shown in Figure 5A-D may be reduced, compared to more asymmetric positioning of the donor substrates (for example, as shown in Figure 4A-C). Placement error may therefore be reduced by prioritising and selecting the preferred target positions of donor substrates 102 to promote symmetry on the acceptor substrate 220, throughout the bonding process (e.g., as shown in Figures 5B and 5C) as well as on the final acceptor substrate 220 with all donor substrates 102 bonded thereon (e.g., as shown in Figure 5D).Additionally, or alternatively, the preferred target position may be determined based on a donor-centre distance. For each target position the respective donor-centre distance is the distance between the target position and a centre of the acceptor substrate 220. In other words, it may be desirable to consider the distance between each donor substrate 102 and the centre of the surface of the acceptor substrate 220 (on which the donor substrates 102 are bonded) when selecting preferred placement position of the subsequent donor substrate 102y.

For example, the preferred target position may be determined based on prioritising target positions having greater donor-centre distance than the donor-centre distance of other target positions. In other words, the preferred target position may be determined based on criteria prioritising target positions which are: at a greater distance from a centre of the acceptor substrate 220 and/or a smaller distance from a periphery of the acceptor substrate 220 (compared to the other target positions). For example, the target position farthest from the centre and/or closest to the periphery of the acceptor substrate 220 may be prioritised. As with all of the prioritisation criteria mentioned herein, the identified target position farthest from the centre may not be selected as the preferred target position because there may be a trade-off with other prioritisation criteria resulting in a target position closer to the centre nonetheless being selected. Optionally, any target position outside a predetermined range of the centre of the acceptor substrate 220 and/or within a predetermined range of the periphery of the acceptor substrate 220 may be prioritised. As shown in Figure 5A, the preferred target positions for each donor substrate of the first set of donor substrates 102a-d may be determined based on prioritising target positions which are: at a greater distance from a centre of the acceptor substrate 220. The preferred target positions for each donor substrate of the first set of donor substrates 102a-d may be the same distance from the centre of the acceptor substrate 220. As shown in Figures 5B-D, this criterion may result in the donor substrates 102 being placed towards the periphery of the acceptor substrate 102 initially, with subsequent donor substrates 102 being placed at increasingly more central positions, for example in circular patterns of decreasing radius, on the acceptor substrate 220 as the process goes on. When placing donor substrates 102 at each radial distance from the centre of the acceptor substrate 220, it might in some scenarios be beneficial to skip one or more target positions at that radial distance and place the donor substrate(s) 102 at those positions at a later stage in the process. For example, donor substrates 102 may be placed at these skipped target positions, for example, in the next round of placing and bonding of donor substrates 102 or after measurement of the distortion of the acceptor substrate 220. In this way, the distortion may grow in a more smooth and symmetrical way.

Additionally, or alternatively, the preferred target position may be determined based on a donor-donor distance. For each target position the donor-donor distance is the distance between that target position and the nearest occupied position on the acceptor substrate at which a preceding donor substrate 102x is bonded (or is planned to have been bonded at the time of bonding the subsequent donor substrate 102y). In other words, it may be desirable to consider the distance between donor substrates 102 when selecting preferred placement position of the subsequent donor substrate 102y. This is because, in some situations, if the subsequent donor substrate 102y is placed very close to an occupied positions, at which a preceding donor substrate 102x has been bonded, there may be a greater increase in distortion of the acceptor substrate 220 compared to if the subsequent donor substrate 102y were placed farther from any occupied positions. However, there may be a trade-off between the desire to reduce distortion and the desire to maintain throughput. This is because, in some situations, if the subsequent donor substrate 102y is placed very far from the preceding donor substrate 102x bonded immediately prior to bonding of the subsequent donor substrate 102y, there may be a greater time taken between completing bonding of the preceding donor substrate 102x and placing of the subsequent donor substrate 102y on the acceptor substrate 220.

For example, the preferred target position may be determined based on criteria prioritising target positions which are not adjacent to, or within a predetermined threshold range of, an occupied position at which a preceding donor substrate 102x is bonded. In other words, it may be desirable that, where possible, a subsequent donor substrate 102y is placed at a preferred target position which is not directly adjacent to, or within the predetermined threshold range of, any of the target positions already associated with preceding donor substrates 102x to be bonded to the acceptor substrate 220 before the subsequent donor substrate 102y. It may be desirable that the preferred target position of the subsequent donor substrate 102y is at least a predetermined minimum distance from any preceding donor substrates 102x. In other words, the donor-donor distance may preferably be at least the predetermined minimum distance. For example, the preferred target position may be determined based on prioritising target positions having a donor-donor distance equal to or greater than the predetermined minimum distance. This is demonstrated, for example by Figures 5B-D. As shown in Figure 5B, in addition to being placed in a symmetrical arrangement and at a distance from the centre of the acceptor substrate 220, the donor substrates 102a-d are also placed such that they are spaced at a distance from each other. Similarly, in Figure 5C, the second set of donor substrates 102e have been placed at preferred target positions which are not directly adjacent to the positions of the first set of donor substrates 102a-d, or to another donor substrate of the second set of donor substrates 102e. In Figure 5D, no suitable target positions remain which meet this criterion and therefore the third set of donor substrates 102f are placed adjacent to preceding donor substrates of the first and second sets of donor substrates 102a-e. Although adjacent placement is undesirable earlier in the donor substrate bonding process, the adjacent placement of donor substrates 102f may be unavoidable if it is desirable to bond donor substrates 102a-f at all available target positions on the acceptor substrate 220. Furthermore, particularly where there is a symmetrical distribution of preceding donor substrates 102a-e, the adjacent bonding of the final (e.g., fourth set of donor substrates 102f in the example of Figure 5D) set of donor substrates may be bonded at positions adjacent to preceding donor substrates 102a-e without causing significant global distortions of the acceptor substrate 220. This is because, the relative influence of bonding these final donor substrates 102f to the acceptor substrate 220 is less than the first set of donor substrates 102a.

Additionally, or alternatively, the preferred target position may be determined based on criteria prioritising target positions within a predetermined maximum distance of the preceding donor substrate 102x. In other words, the donor-donor distance may preferably be less than or equal to the predetermined maximum distance. For example, the preferred target position may be determined based on prioritising target positions having a donor-donor distance less than or equal to the predetermined minimum distance. As explained above, in some scenarios it may be desirable that the subsequent donor substrate 102y is placed at least at the predetermined minimum distance from any preceding donor substrates 102x. Nonetheless, in some scenarios it may also be undesirable for the distance between two donor substrates 102 to be bonded sequentially to be too great. This is because, time is taken for the bonding tool to complete bonding of the preceding donor substrate 102x, retrieve the subsequent donor substrate 102y, and then place the subsequent donor substrate 102y at the respective preferred target position, will, in many instances, be dependent on the distance between the position at which the preceding donor substrate 102x is bonded and the preferred target position at which the subsequent donor substrate 102 is to be bonded. It is desirable that the time taken not to be too great because this will decrease throughput, particularly when there are a large number of donor substrates 102 to be bonded to the acceptor substrate 220. The predetermined maximum distance may be based on: a range of motion of an actuated stage (e.g., movable support structure 250) on which the acceptor substrate 220 is supported; and/or a range of motion of an actuated system for placing the donor substrate 102 on the acceptor substrate 220. In other words, the predetermined maximum distance may be based on: a range of motion of the support structure 250 configured to support the acceptor substrate 220; and/or the range of motion of the actuated system (e.g., support stage 202 or robotic arm) configured to place the donor substrates 102 at the preferred target positions on the acceptor substrate 220. Additionally, or alternatively, the predetermined maximum distance may be based on: a speed of motion of an actuated stage (e.g., movable support structure 250) on which the acceptor substrate 220 is supported; and/or a speed of motion of an actuated system for placing the donor substrate 102 on the acceptor substrate 220. In other words, the predetermined maximum distance may be based on: a speed of motion of the support structure 250 configured to support the acceptor substrate 220; and/or the speed of motion of the actuated system (e.g., support stage 202 or robotic arm) configured to place the donor substrates 102 at the preferred target positions on the acceptor substrate 220. The predetermined maximum distance may therefore be related to a time taken between placement of consecutive donor substrates. The predetermined maximum distance is greater than the predetermined minimum distance. The predetermined maximum distance may be set such that the time taken between placement of consecutive donor substrates is less than or equal to a predetermined maximum time interval. The predetermined maximum time interval may be set based on a desired throughput rate.

Any or all of steps i to iii may be performed after placing of the preceding donor substrate 102x to the acceptor substrate 220, and prior to placing of the subsequent donor substrate 102y at the determined preferred target position. Optionally, any or all of steps i to iii may be performed after bonding of the preceding donor substrate 102x to the acceptor substrate 220, and prior to bonding of the subsequent donor substrate 102y at the determined preferred target position. For example, all of steps i to iii may be performed between bonding of the preceding donor substrate 102x to the acceptor substrate 220 and placing of the subsequent donor substrate 102y at the determined preferred target position. In this way, step i of determining the distortion of the acceptor substrate 220 due to bonding of one or more preceding donor substrates 102x to the acceptor substrate may be performed by measuring the acceptor substrate 220. In particular, a plurality of positions on the surface of the acceptor substrate 220 (to which the donor substrates 102 are to be bonded) and/or the topography of the surface of the acceptor substrate 220 may be measured after bonding of the one or more preceding donor substrates 102x to determine a distortion of the acceptor substrate 220. The measurement of the acceptor substrate 220 and determination of level of distortion may optionally be based on the grid on the surface of the acceptor substrate 220. The measurement enables in-plane deformation of the acceptor substrate 220 to be quantified.

Steps i to iii may be repeated for a plurality of donor substrates 102. Between performing step iii and repeating step i, the subsequent donor substrate may be bonded to the acceptor substrate, at which point what had been the subsequent donor substrate will become a preceding donor substrate for determining a preferred target position of the next subsequent donor substrate. Steps i to iii may be repeated, for example, until there are no remaining donor substrates 102 to be bonded to the acceptor substrate 220, or until there are no remaining unoccupied target positions at which to bond the subsequent donor substrate 102x. The measurement of the acceptor substrate 220 may, optionally, be repeated after each donor substrate 102 is bonded to the acceptor substrate 220. In this way, an accurate determination of the distortion of the acceptor substrate 220 may be obtained for determining the preferred target position of each subsequent donor substrate 102y. Alternatively, to reduce the time taken between bonding of each donor substrate 102 to the acceptor substrate 220, and thus improve throughput, the measurement of the acceptor substrate 220 may be performed at intervals. During each interval, a plurality of donor substrates 102 may be placed on and bonded to the acceptor substrate 220. In other words, the respective preferred target positions may be determined for a plurality of donor substrates 102 (in steps ii and iii) before any re-measurement of the acceptor substrate 220 is performed (to repeat step i). This may have the effect of reducing time taken with frequent measurement and therefore increase throughput, and making the process of bonding donor substrates 102 to the acceptor substrate 220 more efficient.

Alternatively, or additionally, any or all of steps i to iii may optionally be performed based on a mathematical model of the acceptor substrate 220 and donor substrates 102. For example, all of steps i to iii may be performed based on the mathematical model. In particular, the mathematical model enables modelling of in-plane deformation of the acceptor substrate 220 due to bonding of the donor substrates 102 to the acceptor substrate 220. The modelling of the deformation, in turn, enables placement errors at the possible target positions to be estimated.

The mathematical model may be used to determine a plurality of target positions, at which donor substrates 102 may be placed on the acceptor substrate 220. The determination of the plurality of target positions may comprise accounting for input factors. The input factors may comprise, for example, factors based on the information included in the placement information, as described above. For example, the mathematical model may be configured to account for input factors including positions of features on the acceptor substrate 220 and/or predetermined desired positions of donor substrates 102 on the acceptor substrate 220. Alternatively, one or more the plurality of target positions may optionally be selected by a user. In other words, user input may be used to determine the plurality of target positions instead of the plurality of target positions being determined automatically based on the mathematical model. Alternatively, a plurality of target positions may be determined automatically based on the mathematical model and may be adjusted based on user inputs. The user inputs may include, but are not limited to, removing one or more target positions from the plurality of target positions, adding one or more target positions to the plurality of target positions, and/or adjusting the location on the modelled acceptor substrate 220 of one or more target positions of the plurality of target positions.

The mathematical model may be used to estimate the distortion caused by placing, and bonding, a first donor substrate 102a to the acceptor substrate 220. The estimation may be repeated for a plurality of the plurality of target positions, optionally for all of the plurality of target positions. The preferred position for the first donor substrate 102a may be determined based on prioritising target positions associated with less distortion of the acceptor substrate 220. Alternatively, or additionally, the preferred target position of the first donor substrate 102a may be selected from among the plurality of target positions, based on prioritisation, for example as described above in relation to the general method. In a preferred arrangement, the mathematical model is configured to prioritise target positions for the first donor substrate 102a which are at a greater distance from a centre of the acceptor substrate 220 (e.g., outside a predetermined range of the centre of the acceptor substrate 220), and/or prioritising target positions which are a smaller distance from a periphery of the acceptor substrate 220 (e.g., within a predetermined range of the periphery of the acceptor substrate 220). Alternatively, the user may select the position of the first donor substrate 102a manually.

Once the preferred target position for the first donor substrate 102a has been determined, and the associated distortion of the acceptor substrate 220 has been determined based on the mathematical model, a preferred target position for the subsequent donor substrate 102y may be determined. In other words, steps i to iii may be performed using the mathematical model to determine the preferred position for the subsequent donor substrate 102y where the first donor substrate 102a is a preceding donor substrate 102x. The mathematical model may then be used to model the bonding of the subsequent donor substrate 102y to the acceptor substrate 220 in the determined preferred target position.

The subsequent donor substrate 102y then becomes a preceding donor substrate 102x for repeating steps i to iii for a further subsequent donor substrate 102y. These steps may then be repeated a plurality of times. This process may be repeated until all donor substrates 102 to be bonded to the acceptor substrate 220, or until there are no more remaining unoccupied target positions at which to place a subsequent donor substrate 102y.

In this way, an order (i.e., a sequence) of bonding donor substrates 102 to the acceptor substrate 220 at the plurality of target positions may be selected based on the determined preferred target positions. The order may optionally be determined in advance, prior to bonding of donor substrates 102 to the acceptor substrate 220. The donor substrates 102 may then be bonded to the acceptor substrate 220 in the selected order.

The order of bonding donor substrates 102 to the acceptor substrate 220 is optionally selected to prioritise increasing, preferably maximising, a number of determined preferred target positions on the acceptor substrate 220. In other words, the order of bonding donor substrates 102 to the acceptor substrate 220 is optionally selected to prioritise bonding as many donor substrates 102 to the acceptor substrate 220 as possible, preferably also without exceeding a predetermined placement error threshold. In this way, a number of donor substrates 102 which can be bonded to the acceptor substrate 220 at an acceptable level of accuracy (i.e., not exceeding a predetermined placement error threshold) may be increased. An increase in the number of donor substrates 102 bonded to each acceptor substrate 220 may be considered to correspond to an increase in useful output for each acceptor substrate 220. Thus, the process of bonding donor substrates 102 to the acceptor substrate 220 in the determined order may increase the efficiency of the process at delivering useful output.

The process may optionally be repeated for a plurality of different preferred target positions of the first donor substrate 102a such that a preferred order may be identified. Alternatively, or additionally, the process may be repeated, optionally through the use of a Stochastic approach, for a plurality of different preferred target positions for the different donor substrates 102 to be bonded to the acceptor substrate 220. The donor substrates 102 may then be bonded to the acceptor substrate 220 in the identified preferred order.

Alternatively, step i, of determining the distortion of the acceptor substrate 220 may be performed based on measurement of the acceptor substrate 220 with one or more preceding donor substrates 102x bonded thereto.

After step i has been performed based on measurement, steps ii and/or step iii may then be performed based on the mathematically model, updated to represent the measured distortion of the acceptor substrate 220.

Alternatively, after step i has been performed based on measurement, step ii, and optionally also step iii, may optionally be performed based on measurement. For example, step ii may be performed based on measuring the grid on the acceptor substrate 220. Step iii, of determining the placement error, may be performed either: based on comparing the expected target positions with the measured target positions based on the measurement on the grid; or based on updating the mathematical model with the measured target positions based on the measurement on the grid and determining the placement error at the plurality of target positions based on the updated mathematical model. In this way, the mathematical model may be used to supplement measurement of the distorted acceptor substrate 220 when one or more donor substrates 102 have been bonded to the acceptor substrate 220.

**In** other words, the mathematical model may optionally be used (in steps i to iii) to determine a plurality of preferred target positions, the corresponding donor substrates 102 may then be bonded to the acceptor substrate 220 at those determined preferred target positions. The acceptor substrate 220, distorted by bonding of the donor substrates 102, may then be measured and the mathematical model updated to more accurately demonstrate the measured level of distortion. The updated mathematical model may then be used to determine a further plurality of preferred target positions, the corresponding donor substrates 102 may then be bonded to the acceptor substrate 220 at those determined preferred target positions before repeating the measurement of the acceptor substrate 220 to again update the mathematical model. In this way, time is not taken to perform the real-life measurement of the acceptor substrate 220 between bonding of each donor substrate 102 to the acceptor substrate 220. However, the measurements are performed at intervals, between bonding of a plurality of donor substrates 102 to the acceptor substrate 220, to correlate the mathematical model to the measured acceptor substrate 220. In this way, the accuracy of the determined placement errors may be improved compared to a process based entirely on the use of the mathematical model predictions without updates based on real-life measurement.

Instead of, or in addition to, selecting the preferred target position of the subsequent donor substrate 102y based on the placement error associated with each of the plurality of target positions, feedforward correction may be applied to compensate for the distortion. A preferred method comprises the steps of: determining a distortion of the acceptor substrate 220 due to bonding of one or more preceding donor substrates 102x to the acceptor substrate 220; determining a placement error made in bonding a subsequent donor substrate 102y due to said distortion at a preferred target position; and placing the subsequent donor substrate 102y at a corrected target position based on the determined placement error at the preferred target position.

In other words, the distortion of the acceptor substrate 220 due to one or more donor substrates 102x (i.e., preceding donor substrates) may be determined in order to determine the placement error, resulting from this distortion, at the preferred target positions at which the next donor substrate 102y (i.e. the subsequent donor substrate) is to be placed. In particular, the preferred target position may be a position on the grid 85 of the acceptor substrate 220 without distortion. The determined placement error may represent a change in position (i.e., distance and direction) between the grid 85 with out distortion and the grid 85 with distortion 95 caused by bonding of the preceding donor substrate(s) 102x. Consequently, the subsequent donor substrate 102y can be placed at the corrected target position, which accounts for the placement error that would otherwise by incurred. Consequently, the placement error of the subsequent donor substrate 102y can be placed at the corrected target position may be significantly less than a corresponding placement error if the subsequent donor substrate 102y had been placed at the preferred target position directly, without accounting for a change in the position caused by distortion of the acceptor substrate 220.

The distortion of the acceptor substrate 220 due to bonding of the preceding donor substrate(s) 102x to the acceptor substrate 220 may be determined ny calculating the distortion based on a mathematical model of the acceptor substrate 220. In other words, the determined distortion and determined placement error may be based on calculations derived from mathematical models. In this way, the distortions and the corresponding corrected target positions may be determined in advance, prior to bonding of donor substrates 102 to the acceptor substrate 220. This pre-determination may reduce an amount of time taken to bond the donor substrates 102 to the acceptor substrate 220. Consequently, the throughput may be improved compared to an arrangement wherein the corrected target positions are determined during the bonding process.

Alternatively, or additionally, the distortion of the acceptor substrate 220 due to bonding of the preceding donor substrate(s) 102x to the acceptor substrate 220 may be determined by measuring the acceptor substrate 220. For example, distortion 95 of the grid 85 on the acceptor substrate 220 may be measured. Measuring the acceptor substrate 220 has the advantage of being likely to more accurately determine the actual distortion, compared to relying on a mathematical model prediction. However, this improvement comes at the cost of decreased throughput due to the time taken to measure the acceptor substrate. For this reason, it may be desirable to measure the acceptor substrate 220 at intervals, rather than between bonding of each donor substrate 102y. Optionally, the mathematical model may be correlated based on the measurements taken. Additionally, or alternatively, the mathematical model may be used to estimate the distortion of the acceptor substrate 220 due to donor substrates 102 bonded to the acceptor substrate 220 during the intervals between measurements of the acceptor substrate 220.

During bonding of the donor substrates 102 to the acceptor substrate 220, the acceptor substrate 220 may be held in place by a clamp. In any of the above-described methods, the acceptor substrate 220 is desirably released from the clamp prior to measuring the acceptor substrate 220 to determine the distortion of the acceptor substrate 220. The measurement may then be taken with the acceptor substrate 220 in a released condition in which the acceptor substrate 220 is not held by the clamp. In this way, the distortion of the acceptor substrate 220 in the released condition may be determined. The acceptor substrate 220 may be returned to a clamped condition, in which the acceptor substrate 220 is held in place by the clamp for bonding of subsequent donor substrates 102y to the acceptor substrate 220.

A computer program may be provided to perform the above-described methods. For example, the computer program may comprise instructions configured to control a bonding tool or bonding system to perform the methods as described above in relation to the present invention.

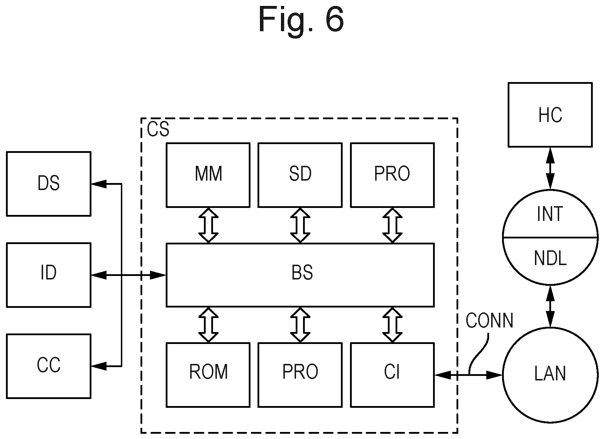

Figure 6 is a diagram of an example computer system CS that may be used for one or more of the operations described herein (e.g., one or more of the operations of method 1700 shown in Fig. 17 and/or other operations). Computer system CS may be included in and/or be similar to and/or the same as the controller(s) described above (e.g., computer system CS may form some or all of the controller(s) described above, two computer systems CS may be used to form two different controllers, etc.). Computer system CS includes a bus BS or other communication mechanism for communicating information, and a processor PRO (or multiple processors) coupled with bus BS for processing information. Computer system CS also includes a main memory MM, such as a random access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a flat panel or touch panel display for displaying information to a computer user or observer. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, all or some of one or more operations described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" or "machine-readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a network. Computer system CS can receive the data and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection CONN through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Various embodiments of the present systems and methods are disclosed in the subsequent list of numbered clauses. In the following, further features, characteristics, and exemplary technical solutions of the present disclosure will be described in terms of clauses that may be optionally claimed in any combination:
1. A method of bonding one or more donor substrates to an acceptor substrate, the method comprising: i. determining a distortion of the acceptor substrate due to bonding of a preceding donor substrate to the acceptor substrate; ii. determining a placement error made in bonding a subsequent donor substrate due to said distortion for a plurality of target positions on the distorted acceptor substrate; and iii. determining a preferred target position based on the determined placement error.
2. The method of clause 1, wherein the location of each target position of the plurality of target positions is based on information comprising information selected from the following group: geometry of the acceptor substrate, positions of features on the acceptor substrate, positions of any donor substrates already bonded to the acceptor substrate, predetermined desired positions of donor substrates on the acceptor substrate, surface activation energy of the acceptor substrate, geometry of a clamp used to hold the donor substrate during placement of the donor substrate for bonding on the acceptor substrate, a range of motion of an actuated stage on which the acceptor substrate is supported, a range of motion of an actuated system for placing the donor substrate on the acceptor substrate, a speed of motion of the actuated stage, and/or a speed of motion of the actuated system for placing the donor substrate on the acceptor substrate.
3. The method of clause 1 or 2, wherein the preferred target position is determined based on a donor-donor distance, wherein for each target position the donor-donor distance is the distance between the target position and the nearest occupied position on the acceptor substrate at which a preceding donor substrate is bonded.
4. The method of clause 3, wherein the preferred target position is determined based on prioritising target positions having a donor-donor distance equal to or greater than a predetermined minimum distance.
5 The method of clause 3 or 4, wherein the preferred target position is determined based on prioritising target positions having a donor-donor distance less than or equal to a predetermined maximum distance.
6. The method of clause 5, wherein the predetermined maximum distance is based on: a range of motion of an actuated stage on which the acceptor substrate is supported; and/or a range of motion of an actuated system for placing the donor substrate on the acceptor substrate.
7. The method of clause 5 or 6, wherein the predetermined maximum distance is based on: a speed of motion of the actuated stage on which the acceptor substrate is supported; and/or a speed of motion the actuated system for placing the donor substrate on the acceptor substrate.
8. The method of any preceding clause, wherein the preferred target position is determined based on a donor-centre distance, wherein for each target position the respective donor-centre distance is the distance between the target position and a centre of the acceptor substrate.
9. The method of clause 8, wherein the preferred target position is determined based on prioritising target positions having greater donor-centre distance than the donor-centre distance of other target positions among the plurality of target positions.
10. The method of any preceding clause, wherein the preferred target position is determined based on prioritising target positions which are either:
   in a position which is symmetric, with respect to a centre of the acceptor substrate, to an occupied position at which a preceding donor substrate is bonded; or,
   in a position which is symmetric, with respect to the centre of the acceptor substrate, to another target position, at which another donor substrate may be subsequently bonded.
11. The method of any preceding clause, wherein steps i to iii are performed after bonding of the preceding donor substrate to the acceptor substrate, and prior to bonding of the subsequent donor substrate at the determined preferred target position.
12. The method of clause 11, wherein step i of determining the distortion of the acceptor substrate is performed by measuring a topography of the acceptor substrate.
13. The method of any preceding clause, wherein steps i to iii are repeated for a plurality of donor substrates, until there are no remaining target positions at which to bond the subsequent donor substrate.
14. The method of clause 13, wherein, between performing step iii and repeating step i, the subsequent donor substrate is bonded to the acceptor substrate and becomes a preceding donor substrate.
15. The method of any of clauses 1 to 11, wherein steps i to iii are performed based on a mathematical model in-plane deformation of the acceptor substrate due to the bonding of one or more donor substrates.
16. The method of clause 15, wherein steps i to iii are preformed prior to bonding of donor substrates to the acceptor substrate.
17. The method of clause 16, wherein steps i to iii are repeated for a plurality of donor substrates, until there are no remaining target positions at which to bond the subsequent donor substrate.
18. The method of clause 17, wherein an order of bonding donor substrates to the acceptor substrate at the plurality of target positions is selected based on the determined preferred target positions.
19. The method of clause 18, wherein the order of bonding donor substrates to the acceptor substrate is selected to prioritise maximising a number of determined preferred target positions on the acceptor substrate.
20. The method of clause 18 or 19, further comprising bonding the donor substrates to the acceptor substrates in the determined order.
21. A method of bonding one or more donor substrates to an acceptor substrate, the method comprising: determining a distortion of the acceptor substrate due to bonding of one or more preceding donor substrates to the acceptor substrate; determining a placement error made in bonding a subsequent donor substrate due to said distortion at a preferred target position; and placing the subsequent donor substrate at a corrected target position based on the determined placement error at the preferred target position.
22. The method of clause 21, wherein determining the distortion of the acceptor substrate due to bonding of the preceding donor substrate to the acceptor substrate comprises calculating the distortion based on a mathematical model of in-plane deformation the acceptor substrate due to the bonding of one or more donor substrates.
23. The method of clause 21, wherein determining the distortion of the acceptor substrate due to bonding of the preceding donor substrate to the acceptor substrate comprises measuring a topography of the acceptor substrate.
24. The method of clause 23, further comprising releasing the acceptor substrate from a clamp prior to measuring the acceptor substrate to determine the distortion of the acceptor substrate, wherein the clamp is configured to hold the acceptor substrate during bonding of donor substrates to the acceptor substrate.
25. The method of any preceding clause, wherein the donor substrate is a die and the acceptor substrate is a wafer.
26. A computer program comprising instructions configured to control a bonding system to perform the method of any preceding clause.
27. A bonding tool for bonding donor substrates to an acceptor substrate, the bonding tool being configured to position a subsequent donor substrate at a preferred target position based on a determined placement error due to distortion of the acceptor substrate due to bonding of a preceding donor substrate to the acceptor substrate.
28. A bonding system for bonding donor substrates to an acceptor substrate, the bonding system comprising the bonding tool of clause 27; and a determination unit configured to: determine a distortion of the acceptor substrate due to bonding of a preceding donor substrate to the acceptor substrate; determine a placement error made in bonding a subsequent donor substrate due to said distortion for a plurality of target positions on the distorted acceptor substrate; and determine the preferred target position based on the determined placement error.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the claims.

The descriptions above are intended to be illustrative, not limiting. Thus, it will be apparent to one skilled in the art that modifications may be made as described without departing from the scope of the claims.

## Claims

1. A method of bonding one or more donor substrates to an acceptor substrate, the method comprising:
i. determining a distortion of the acceptor substrate due to bonding of a preceding donor substrate to the acceptor substrate;
ii. determining a placement error made in bonding a subsequent donor substrate due to said distortion for a plurality of target positions on the distorted acceptor substrate; and
iii. determining a preferred target position based on the determined placement error.

2. The method of claim 1, wherein the location of each target position of the plurality of target positions is based on information comprising information selected from the following group:
geometry of the acceptor substrate, positions of features on the acceptor substrate, positions of any donor substrates already bonded to the acceptor substrate, predetermined desired positions of donor substrates on the acceptor substrate, surface activation energy of the acceptor substrate, geometry of a clamp used to hold the donor substrate during placement of the donor substrate for bonding on the acceptor substrate, a range of motion of an actuated stage on which the acceptor substrate is supported, a range of motion of an actuated system for placing the donor substrate on the acceptor substrate, a speed of motion of the actuated stage, and/or a speed of motion of the actuated system for placing the donor substrate on the acceptor substrate.

3. The method of claim 1, wherein the preferred target position is determined based on a donor-donor distance, wherein for each target position the donor-donor distance is the distance between the target position and the nearest occupied position on the acceptor substrate at which a preceding donor substrate is bonded.

4. The method of claim 3, wherein the preferred target position is determined based on prioritising target positions having a donor-donor distance equal to or greater than a predetermined minimum distance.

5. The method of claim 3, wherein the preferred target position is determined based on prioritising target positions having a donor-donor distance less than or equal to a predetermined maximum distance.

6. The method of claim 5, wherein the predetermined maximum distance is based on:
a range of motion of an actuated stage on which the acceptor substrate is supported; and/or
a range of motion of an actuated system for placing the donor substrate on the acceptor substrate.

7. The method of claim 5, wherein the predetermined maximum distance is based on:
a speed of motion of the actuated stage on which the acceptor substrate is supported; and/or
a speed of motion the actuated system for placing the donor substrate on the acceptor substrate.

8. The method of claim 1, wherein the preferred target position is determined based on a donor-centre distance, wherein for each target position the respective donor-centre distance is the distance between the target position and a centre of the acceptor substrate.

9. The method of claim 8, wherein the preferred target position is determined based on prioritising target positions having greater donor-centre distance than the donor-centre distance of other target positions among the plurality of target positions.

10. The method of claim 1, wherein the preferred target position is determined based on prioritising target positions which are either:
in a position which is symmetric, with respect to a centre of the acceptor substrate, to an occupied position at which a preceding donor substrate is bonded; or,
in a position which is symmetric, with respect to the centre of the acceptor substrate, to another target position, at which another donor substrate may be subsequently bonded.

11. The method of claim 1, wherein steps i to iii are performed after bonding of the preceding donor substrate to the acceptor substrate, and prior to bonding of the subsequent donor substrate at the determined preferred target position.

12. The method of claim 11, wherein step i of determining the distortion of the acceptor substrate is performed by measuring a topography of the acceptor substrate.

13. The method of claim 1, wherein steps i to iii are performed based on a mathematical model in-plane deformation of the acceptor substrate due to the bonding of one or more donor substrates.

14. A bonding tool for bonding donor substrates to an acceptor substrate, the bonding tool being configured to position a subsequent donor substrate at a preferred target position based on a determined placement error due to distortion of the acceptor substrate due to bonding of a preceding donor substrate to the acceptor substrate.

15. A bonding system for bonding donor substrates to an acceptor substrate, the bonding system comprising the bonding tool of claim 14; and
a determination unit configured to:
determine a distortion of the acceptor substrate due to bonding of a preceding donor substrate to the acceptor substrate;
determine a placement error made in bonding a subsequent donor substrate due to said distortion for a plurality of target positions on the distorted acceptor substrate; and
determine the preferred target position based on the determined placement error.
